# EUROPEAN PATENT APPLICATION

(11) **EP 4 318 569 A1**
(43) Date of publication of application: **07.02.2024**
(21) Application number: 21945532.6
(22) Date of filing: 18.06.2021
(51) Int. Cl.: H01L 23/34

(54) **DIE PACKAGE STRUCTURE AND PREPARATION THEREFOR, AND PACKAGE SYSTEM**

(71) Applicant: Huawei Technologies Co., Ltd., Shenzhen, Guangdong 518129 (CN)
(72) Inventor: KANG, Le, Shenzhen, Guangdong 518129 (CN); LIU, Xiaoguo, Shenzhen, Guangdong 518129 (CN); YUAN, Lingcheng, Shenzhen, Guangdong 518129 (CN); XU, Bin, Shenzhen, Guangdong 518129 (CN); HE, Zhiqiang, Shenzhen, Guangdong 518129 (CN)
(74) Representative: Körber, Martin Hans
(86) International application number: PCT/CN2021/100936
(87) International publication number: WO 2022/261947

(57) **Abstract**

This application provides a die package structure, a method for fabricating the same, and a package system. The die package structure includes a package substrate, a die (die), and a first package body. The package substrate has a first surface and a second surface that are opposite to each other. The die is coupled to the package substrate, and the die has a hotspot. A heat dissipation connection point is disposed on the first surface of the package substrate, and a heat conduction channel that communicates the heat dissipation connection point with the hotspot is formed in the package substrate. A first connection terminal for connecting to an external device is disposed on the second surface. The first package body is disposed on the first surface, a heat conduction structure is formed in the first package body, and the heat conduction structure extends from the heat dissipation connection point to a surface of the first package body. Because a position of the heat dissipation connection point corresponds to a position of the hotspot of the die, heat of the hotspot of the die may be dissipated in a targeted manner by using the heat dissipation connection point and the heat conduction structure. The heat conduction structure may be flexibly disposed, and structure formation of the heat conduction structure can be closely combined with a process of fabricating the die package structure.

## Description

### TECHNICAL FIELD

This application relates to the field of die package technologies, and in particular, to a die package structure, a method for fabricating the same, and a package system.

### BACKGROUND

Compared with a conventional package that is performed on only one semiconductor wafer, a SIP (system in pack, system in package) package may be performed to integrate one or more semiconductor wafers and peripheral devices of the semiconductor wafers into a package structure. In a conventional two-dimensional (2D) SIP or 2.5D SIP package, a semiconductor wafer and a peripheral device are placed on one surface of a substrate or an RDL (redistribution layer, redistribution layer), and device layout utilization is limited. In a 3D system in package, layout space of the SIP package may be fully used, and a semiconductor wafer and a peripheral device are placed on different surfaces or at different positions (upper, lower, and inside) of a substrate or an RDL by using a technology such as an embedding technology, a double-sided mount technology, or an injection molding technology, thereby increasing device layout density and further implementing an advanced package form for SIP miniaturization.

As sales of 5G mobile phones and wearable products continue to be booming, requirements for motherboard utilization and differentiated module customization are also continuously increasing. In this context, widespread application of the SIP has become a hot topic. Currently, a conventional SIP and the 3D SIP are widely applied to electronic products to improve product competitiveness. However, more devices in the 3D SIP lead to growing power density of various dies. When the 3D SIP operates, more electric energy is consumed. Consequently, heat emission is caused. Therefore, thermal performance of die packaging is receiving increasing attention. However, currently a heat dissipation path for a 3D SIP structure has relatively high thermal resistance, and has a disadvantage that targeted heat dissipation is poor.

### SUMMARY

This application provides a die package structure, a method for fabricating the same, and a package system, to dissipate heat of a centralized hotspot on a die in a targeted manner, to improve heat dissipation effect of the structure.

According to a first aspect, this application provides a die package structure, where the die package structure may be coupled to a circuit board to form a package system. The die package structure includes a package substrate, a die (die), and a first package body. The package substrate supports the entire structure, and has a first surface and a second surface that are opposite to each other. The die is coupled to the package substrate, and the die has a hotspot. For example, the hotspot generates a relatively large quantity of heat with relatively high temperature when the die operates. A heat dissipation connection point is disposed on the first surface of the package substrate, and a heat conduction channel that communicates the heat dissipation connection point with the hotspot is formed in the package substrate. A first connection terminal for connecting to an external device is disposed on the second surface. When the die package structure is coupled to the circuit board, specifically, the first connection terminal is coupled to the circuit board. The first package body is disposed on the first surface, a heat conduction structure is formed in the first package body, and the heat conduction structure extends from the heat dissipation connection point to a surface of the first package body.

In the foregoing die package structure, because a position of the heat dissipation connection point corresponds to a position of the hotspot of the die, heat of the hotspot of the die may be dissipated in a targeted manner by using the heat dissipation connection point and the heat conduction structure. This is equivalent to that the heat conduction structure is disposed in the die package structure, may be flexibly disposed based on package structures of different standards, and may further be closely combined with a process of fabricating the die package structure.

It should be understood that the heat conduction structure in the foregoing die package structure may be made of a material with low thermal resistance, and has relatively good heat-conducting performance. This helps conduct heat of the hotspot from a heat dissipation connection point to a surface of the structure. Specifically, a thermal resistance value of the heat conduction structure is lower than at least that of the first package body, to increase heat dissipation efficiency. In some possible implementations, the thermal resistance value of the heat conduction structure may be lower than a thermal resistance value of another non-conductor wrapping material, to adapt to more use scenarios.

The die package structure further includes an electronic device disposed on the first surface, where the first package body wraps the electronic device, and an electrical channel that communicates the electronic device with the die is formed in the package substrate. However, a second connection terminal configured to connect to the package substrate is further disposed on one surface that is of the die and that faces the first package body. To protect the die package structure, a protective coating may be further formed on the surface of the first package body. When the protective coating is made of a metal material, heat conducted by the heat conduction structure may be quickly dissipated, to further improve heat dissipation effect. The heat dissipation connection point may be specifically a heat dissipation pad. However, a shape of the heat conduction structure is not limited herein, and may be set based on a specific implementation condition.

During actual application, the die package structure has various structure standards. A 3D SIP structure is used as an example. When the die package structure is of a double-sided mount SIP standard, the package substrate includes a substrate, a first solder mask is formed on a surface that is of the substrate and that faces the first package body, and a second solder mask is formed on a surface that is of the substrate and that is away from the first package body. The die is coupled to a surface that is of the second solder mask and that is away from the first package body, a second package body wrapping the die is further disposed on the surface that is of the second solder mask and that is away from the first package body, and the first connection terminal protrudes from the second package body.

When the die package structure is of a SIP standard for which a semiconductor is embedded into a substrate, the package substrate includes a substrate, a first solder mask is formed on a surface that is of the substrate and that faces the first package body, and a second solder mask is formed on a surface that is of the substrate and that is away from the first package body. The die is embedded in the substrate.

When the die package structure is a laminated fanout SIP standard, along a direction pointing from the first surface to the second surface, the package substrate includes a first redistribution layer, a plastic packaging layer, and a second redistribution layer that are disposed in a stacked manner, and a connector configured to connect the first redistribution layer and the second redistribution layer is disposed in the plastic packaging layer. The die is coupled between the first redistribution layer and the second redistribution layer and is circumferentially wrapped by the plastic packaging layer, a first pad configured to connect to the first connection terminal is disposed in the second redistribution layer, and a via configured to communicate the first pad with the connector is further formed in the second redistribution layer. A dielectric layer is further disposed between the die and the second redistribution layer. The dielectric layer herein is configured to fasten the die to the second redistribution layer, and the dielectric layer may select a double-sided tape.

According to a second aspect, based on a structure of a die package structure, this application further provides a package system. The package system includes a circuit board and any one of the foregoing die package structures. The circuit board is coupled to the die package structure by using a first connection terminal. During application, the circuit board may export a signal of a die and communicate with an external device, to help the system implement a function. The circuit board herein may be a PCB (printed circuit board, printed circuit board), an FPC (flexible circuit board, flexible circuit board), or an FPCB (flexible printed circuit board, flexible printed circuit board).

According to a third aspect, based on a structure of a die package structure, this application further provides a method for fabricating a die package structure. The method is used to fabricate the foregoing die package structure, and specifically includes the following steps:
providing a package substrate coupled to a die, where the die has a hotspot, the package substrate has a first surface and a second surface that are opposite to each other, and the package substrate has a heat conduction channel in communication with the hotspot;
disposing, on the first surface of the package substrate, a heat dissipation connection point connected to the heat conduction channel;
forming, on the first surface of the package substrate, a first package body having a heat conduction structure, where the heat conduction structure extends from the heat dissipation connection point to a surface of the first package body; and
forming a first connection terminal on the second surface of the package substrate.

The step of forming, on the first surface of the package substrate, a first package body having a heat conduction structure, where the heat conduction structure extends from the heat dissipation connection point to a surface of the first package body may include the following steps:
generating the heat conduction structure on the heat dissipation connection point by using a technology such as growth or soldering; and
forming the first package body on the first surface of the package substrate, where one end that is of the heat conduction structure and that is away from the heat dissipation connection point is located on the surface of the first package body.

Alternatively, the step of forming, on the first surface of the package substrate, a first package body having a heat conduction structure, where the heat conduction structure extends from the heat dissipation connection point to a surface of the first package body may include the following steps:
forming the first package body on the first surface of the package substrate;
opening a hole inwards on the surface of the first package body to form a preset hole in communication with the heat dissipation connection point; and
generating the heat conduction structure in the preset hole through pouring, implanting, or the like.

### BRIEF DESCRIPTION OF THE DRAWINGS

FIG. 1a to FIG. 1c are schematic diagram of a structures of a package structure that dissipates heat downwards by using a circuit board;
FIG. 1d to FIG. 1f are schematic diagram of a structures of a package structure that dissipates heat upwards by using an entire system structure;
FIG. 2a to FIG. 2c are schematic diagram of a structures of cross sections of a die package structure according to an embodiment of this application;
FIG. 3a to FIG. 3f are schematic diagram of a structures of a heat conduction structure in a die package structure according to an embodiment of this application;
FIG. 4a is a schematic diagram of a structure of a cross section of a die package structure according to an embodiment of this application;
FIG. 4b is a schematic diagram of a structure of a cross section of A-A in FIG. 4a;
FIG. 4c is a schematic diagram of a position relationship between a heat conduction structure and a plurality of centralized hotspots in a die package structure according to an embodiment of this application;
FIG. 4d is a schematic diagram of a structure of the heat conduction structure in FIG. 4c;
FIG. 4e is a schematic diagram of a position relationship between a heat conduction structure and a plurality of centralized hotspots in a die package structure according to an embodiment of this application;
FIG. 4f is a schematic diagram of a structure of the heat conduction structure in FIG. 4e;
FIG. 5a is a schematic diagram of a structure of a cross section of a die package structure according to an embodiment of this application;
FIG. 5b is a schematic diagram of a structure of a cross section of B-B in FIG. 5a;
FIG. 6a is a schematic diagram of a structure of a cross section of a die package structure according to an embodiment of this application;
FIG. 6b is a schematic diagram of a structure of a cross section of C-C in FIG. 6a;
FIG. 7 is a schematic flowchart of a method for fabricating a die package structure according to an embodiment of this application;
FIG. 8 is a schematic diagram of a partial structure of a die package structure according to an embodiment of this application;
FIG. 9 is a schematic flowchart of fabricating a heat conduction structure in a method for fabricating a die package structure according to an embodiment of this application;
FIG. 10 is a schematic diagram of a structure change in the fabrication method shown in FIG. 9;
FIG. 11 is a schematic flowchart of fabricating a heat conduction structure in a method for fabricating a die package structure according to an embodiment of this application;
FIG. 12a and FIG. 12b are schematic diagrams of structure changes in the fabrication method shown in FIG. 11; and
FIG. 13a to FIG. 13c are schematic diagram of a structures of cross sections of a package system according to an embodiment of this application.

### DESCRIPTION OF EMBODIMENTS

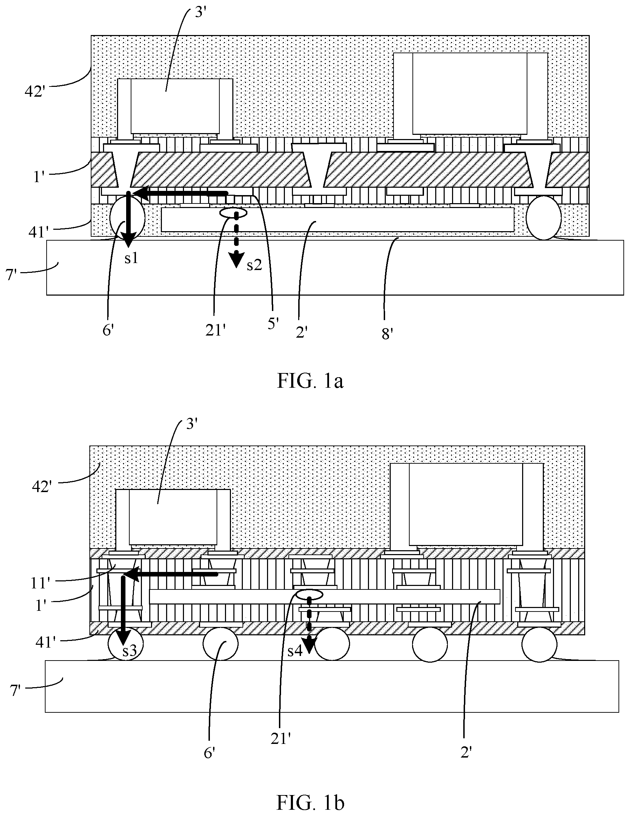

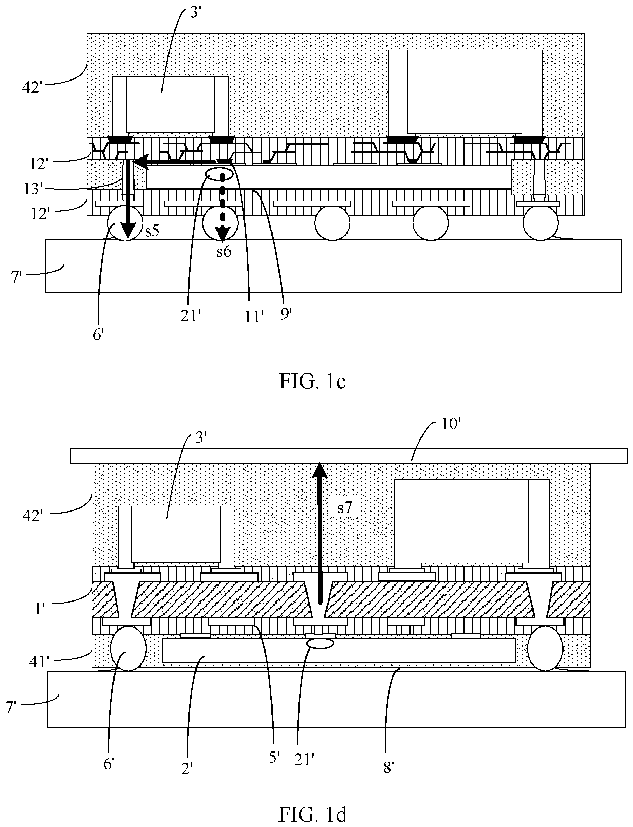

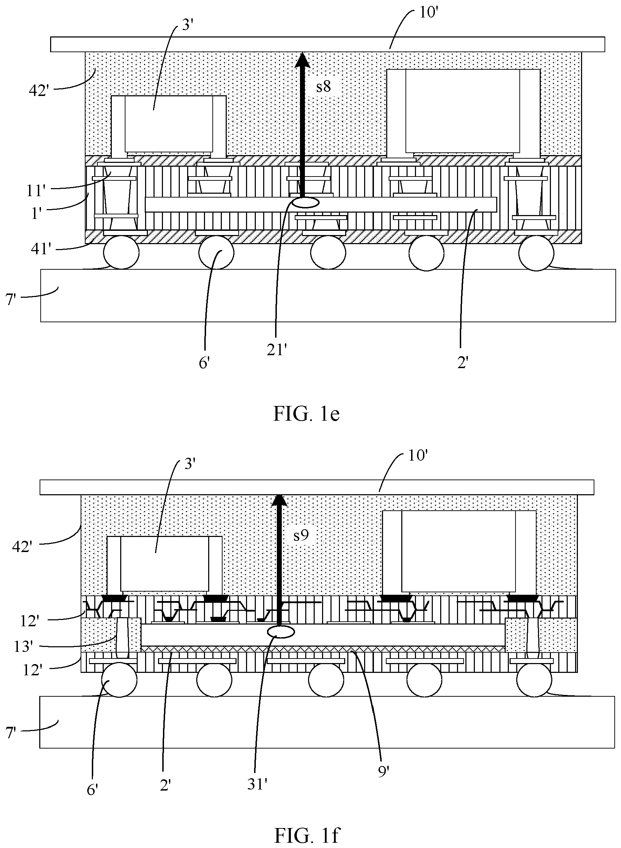

Development of intelligent electronic products increasingly tends to be miniaturized, and heat dissipation of die packaging in a package system is highly valued. A 3D SIP structure is used as an example. Currently, heat dissipation of a package structure mainly includes performing heat dissipation downwards by using a circuit board and performing heat dissipation upwards by using an entire system structure. Specifically, with reference to FIG. 1a to FIG. 1c, the package structure dissipates heat downwards by using the circuit board. As shown in FIG. 1a, a double-sided mount SIP structure is used. A die 2' and an electronic device 3' are respectively coupled to two sides of a substrate 1', the die 2' is wrapped by a first package body 41', and the electronic device 3' is wrapped by a second package body 42'. The die 2' has a centralized hotspot 21', and the die 2' conducts heat of the centralized hotspot 21' to a circuit board 7' through a heat dissipation path s1 (indicated by a solid arrow) and s2 (indicated by a dashed arrow) for heat dissipation, s1 specifically passes through a pad 5', the substrate 1', and a solder ball 6', and s2 specifically passes through the die 2', the first package body 41', and glue 8'. In a SIP structure for which a semiconductor is embedded in a substrate and that is shown in FIG. 1b, a die 2' conducts heat of a centralized hotspot 21' to a circuit board 7' through a heat dissipation path s3 (indicated by a solid arrow) and s4 (indicated by a dashed arrow) for heat dissipation, s3 specifically passes through a via 11', a substrate 1', a via 11', and a solder ball 6', and s4 specifically passes through the die 2', the substrate 1', and the solder ball 6'. In a laminated fanout (fanout) SIP structure shown in FIG. 1c, a die 2' conducts heat of a centralized hotspot 21' to a circuit board 7' through a heat dissipation path s5 (indicated by a solid arrow) and s6 (indicated by a dashed arrow) for heat dissipation, s5 specifically passes through a via 11', a circuit layer 12', a copper column 13', and a solder ball 6', and s6 specifically passes through the die 2', a glue layer 9', the circuit layer 12', and the solder ball 6'. With reference to FIG. 1d to FIG. 1f, the package structure dissipates heat upwards by using the entire system structure. A housing 10' (which may be specifically a graphite sheet or an entire system housing) is disposed on one side of a second package body 42' of the package structure. As shown in FIG. 1d, a die 2' conducts heat of a centralized hotspot 21' to an entire system mechanical part through a heat dissipation path s7 for heat dissipation, and s7 specifically passes through a pad 5', a substrate 1', the second package body 42', and the housing 10'. In a SIP structure for which a semiconductor is embedded in a substrate and that is shown in FIG. 1e, a die 2' conducts heat of a centralized hotspot 21' to an entire system mechanical part through a heat dissipation path s8 for heat dissipation, and s8 specifically passes through a substrate 1', a via 11', a second package body 42', and a housing 10'. In a laminated fanout (fanout) SIP structure shown in FIG. 1f, a die 2' conducts heat of a centralized hotspot 21' to an entire system mechanical part through a heat dissipation path s9 for heat dissipation, and s9 specifically passes through a circuit layer 12', a second package body 42', and a housing 10'. All the heat dissipation paths in the foregoing two heat dissipation manners are relatively long. Thermal resistance of some materials on the heat dissipation paths is relatively high (for example, the second package body 42' with high heat conductivity), and especially, heat of the die cannot be dissipated in a targeted manner. Consequently, an increasingly high heat dissipation requirement cannot be met.

Therefore, an embodiment of this application provides a die package structure, to improve a heat dissipation capability of the package structure, and dissipate heat of a die in a targeted manner. To make objectives, technical solutions, and advantages of this application clearer, the following further describes this application in detail with reference to accompanying drawings.

Terms used in the following embodiments are merely intended to describe particular embodiments, but are not intended to limit this application. The terms "one", "a", "the", "the foregoing", "this", and "the one" in singular forms used in this specification and the appended claims of this application are also intended to include expressions such as "one or more", unless otherwise specified in the context clearly.

Reference to "one embodiment", "some embodiments", or the like described in this specification means that a particular feature, structure, or characteristic described with reference to one or more embodiments is included in one or more embodiments of this application. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

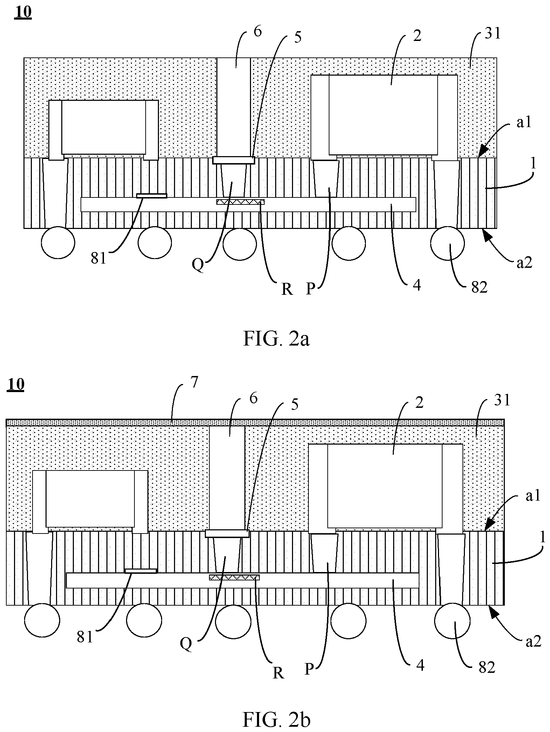

FIG. 2a is a schematic diagram of a structure of a cross section of a die package structure 10 according to an embodiment of this application. For clear description, for the die package structure 10, only several simple and necessary structures and approximate positions of the structures are shown herein. The die package structure 10 includes a package substrate 1. The package substrate 1 herein is a multilayer plate-shaped structure, may include a plurality of RDLs, and has a first surface a1 and a second surface a2 that are opposite to each other. An electronic device 2 and a first package body 31 that wraps the electronic device 2 are coupled on the first surface a1 of the package substrate 1. A die 4 is coupled to the package substrate 1 (a position of the die 4 on the package substrate 1 is not limited, and the die 4 may be coupled to a surface of the package substrate 1, or may be coupled inside the package substrate 1 in an embedded manner. Herein, an example in which the die 4 is embedded in the package substrate 1 is used). An electrical channel P that communicates the electronic device 2 with the die 4 is formed in the package substrate 1, and an internal connection terminal 81 configured to connect to the package substrate 1 is disposed on a surface that is of the die 4 and that faces the first package body 31. A first connection terminal 82 is disposed on the second surface a2 of the package substrate 1, and the first connection terminal 82 is coupled to a circuit board or another device to implement an electrical signal connection.

In the die package structure 10 shown in FIG. 2a, the die 4 has a hotspot R, and the hotspot R is, for example, an area in which heat is concentrated and is in a large quantity when the die 4 operates. To dissipate heat of the hotspot R of the die 4 out, a heat dissipation connection point 5 is disposed on the first surface a1 of the package substrate 1, and the heat dissipation connection point 5 is shown by using a structure of a pad. In addition, a heat conduction channel Q that communicates the heat dissipation connection point 5 with the hotspot R is formed inside the package substrate 1, and a heat conduction structure 6 is disposed in the first package body 31. One end of the heat conduction structure 6 is connected to the heat dissipation connection point 5, and the other end is located on a surface of the first package body 31. This is equivalent to that the heat conduction structure 6 extends from the heat dissipation connection point 5 to the surface of the first package body 31. The first package body 31 herein may be made of a material with low thermal resistance, and has relatively good heat-conducting performance. Because a position of the heat dissipation connection point 5 corresponds to a position of the hotspot R of the die 4, the heat of the hotspot R of the die 4 may be dissipated in a targeted manner by using the heat dissipation connection point 5 and the heat conduction structure 6.

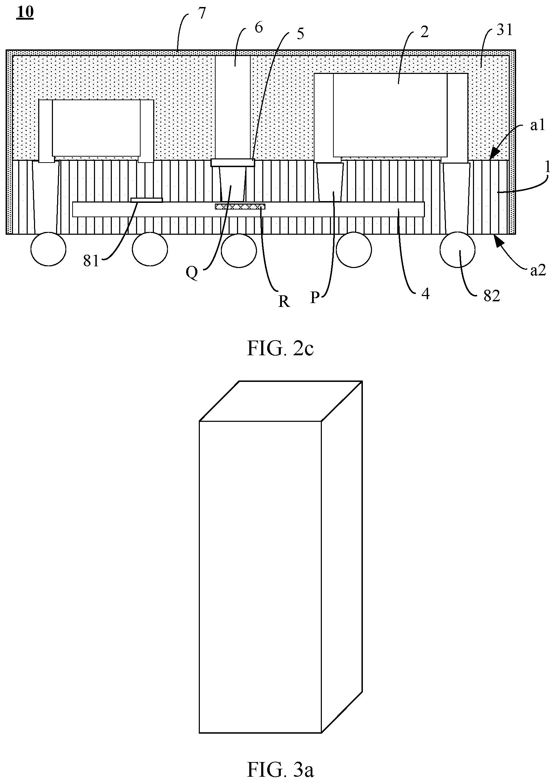

It should be understood that a thermal resistance value of the heat conduction structure 6 is lower than a thermal resistance value of the first package body 31. Compared with a conventional technology, the heat conduction structure 6 can equivalently provide a faster heat conduction channel for heat dissipation, thereby increasing heat conduction efficiency. The thermal resistance value of the heat conduction structure 6 may be further less than a thermal resistance value of another non-conductor wrapping material, so that the package structure 10 provided in this embodiment of this application adapts to a wider use scenario. As shown in FIG. 2b, a protective coating 7 may be formed on the surface of the first package body 31 through a sputtering process. When the protective coating 7 is made of a metal material, heat dissipated from the heat conduction structure 6 can be quickly dissipated through the protective coating 7, thereby enhancing heat dissipation effect of the structure. As shown in FIG. 2c, a protective coating 7 may be formed, through a sputtering process, on a surface of the die package structure 10 except a side (a side for interconnecting to a circuit board) on which the first connection terminal 82 is disposed. The protective coating 7 may implement a function of a shielding can, and requirements of the protective coating 7 on an area and a height are less than that of a conventional shielding can, thereby helping implement miniaturization of the entire structure.

The electronic device 2 in the foregoing embodiment may be a passive device, may be an active device, or may be another device, for example, one or a combination of a resistor, a capacitor, and an inductor. It should be understood that the die 4 herein is an unpackaged bare die.

The heat conduction structure 6 may be formed on the heat dissipation connection point 5 in at least one manner including soldering, growth, injection molding, implantation, or the like.

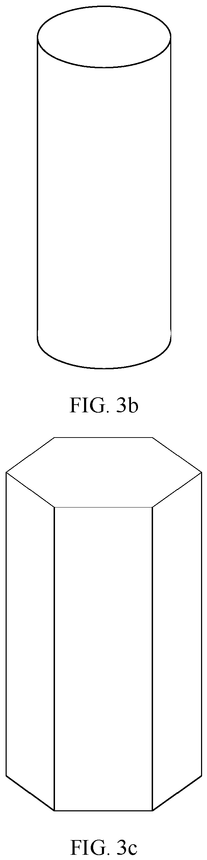

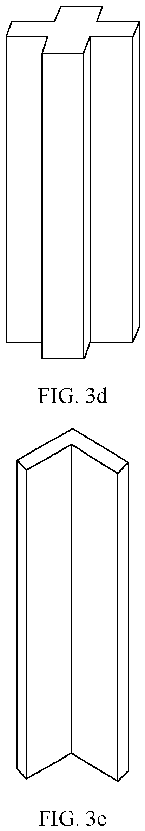

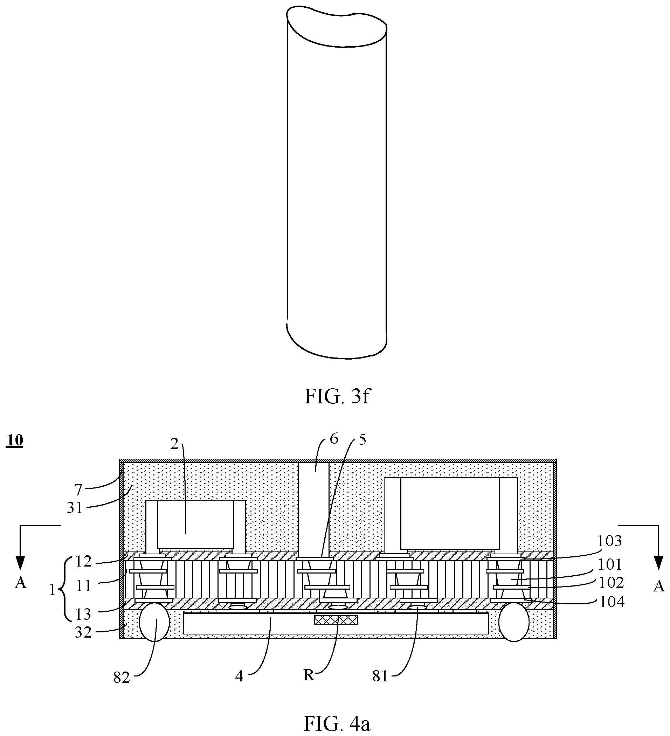

FIG. 3a to FIG. 3e show examples of several heat conduction structures 6 in different shapes. On a surface perpendicular to an extension direction of the heat conduction structure 6, a cross section of the heat conduction structure 6 may be a rectangle (as shown in FIG. 3a), a circle (as shown in FIG. 3b), a polygon (as shown in FIG. 3c), a cross (as shown in FIG. 3d), a fold line (as shown in FIG. 3e), or even in an irregular shape (as shown in FIG. 3f). This is not limited herein.

During actual application, the die package structure has various structure standards. A 3D SIP structure is used as an example. The die package structure may include a structure such as a double-sided mount SIP, a SIP for which a semiconductor is embedded in a substrate, and a laminated fanout SIP. The following further describes the die package structure 10 provided in this application by using 3D SIP structures of different standards as examples.

FIG. 4a shows a die package structure 10 of a double-sided mount SIP standard. A package substrate 1 of the die package structure 10 specifically includes a substrate 11 and a first solder mask 12 and a second solder mask 13 that are formed on two surfaces of the substrate 11, and the substrate 11 specifically includes a plurality of redistribution layers. A surface that is of the first solder mask 12 and that is away from the substrate 11 is equivalent to a first surface a1 of the package substrate 1, and a surface that is of the second solder mask 13 and that is away from the substrate 11 is equivalent to a second surface a2 of the package substrate 1. An electronic device 2 is disposed on a surface of the first solder mask 12 and is wrapped by a first package body 31. A die 4 is disposed on a surface of the second solder mask 13 and is wrapped by a second package body 32. An internal connection terminal 81 is disposed on a surface that is of the die 4 and that faces the first package body 31. The first connection terminal 82 is disposed on a side that is of the second solder mask 13 and that is away from the substrate 11, and the first connection terminal 82 protrudes from the second package body 32, to be coupled to the circuit board to implement an electrical signal connection. An electrical channel P that is formed in the substrate 11 and that is configured to connect the electronic device 2 and the die 4 specifically includes a via 101 and an inner circuit 102 that are disposed in the substrate 11. The via 101 and the inner circuit 102 are distributed in the substrate 11 as required. On the surface that is of the substrate 11 and on which the first solder mask 12 is disposed, a first soldering point 103 (the first soldering point 103 is connected to the via 101 herein) connected to the electrical channel P is further disposed, and the electronic device 2 is connected to the first soldering point 103. On the surface that is of the substrate 11 and on which the second solder mask 13 is disposed, a second soldering point 104 (the second soldering point 104 is connected to the via 101 herein) connected to the electrical channel P is disposed. Some of second soldering points 104 are connected to the internal connection terminal 81 disposed on the die 4, to implement a signal connection between the die 4 and the package substrate 1, and some of the second soldering points 104 are connected to the first connection terminal 82 to implement a signal connection between the first connection terminal 82 and the package substrate 1. A protective coating 7 is formed, through a sputtering process, on a surface of the die package structure 10 except a side (a side for interconnecting to a circuit board) on which the first connection terminal 82 is disposed.

To dissipate heat of a hotspot R on the die 4, a heat dissipation connection point 5 is specifically located on the surface that is of the substrate 11 and on which the first solder mask 12 is disposed, and the first solder mask 12 has an opening that exposes the heat dissipation connection point 5 (equivalent to that the heat dissipation connection point 5 is located on the first surface a1 of the package substrate 1). The electrical channel P located between the heat dissipation connection point 5 and the hotspot R may serve as a heat conduction channel Q. In the structure shown in FIG. 4a, the heat conduction channel Q is equivalently formed by the via 101 and the inner circuit 102, so that the heat of the hotspot R on the die 4 is transferred to a surface of the first package body 31 through the internal connection terminal 81, the via 101, the inner circuit 102, the heat dissipation connection point 5, and a heat conduction structure 6.

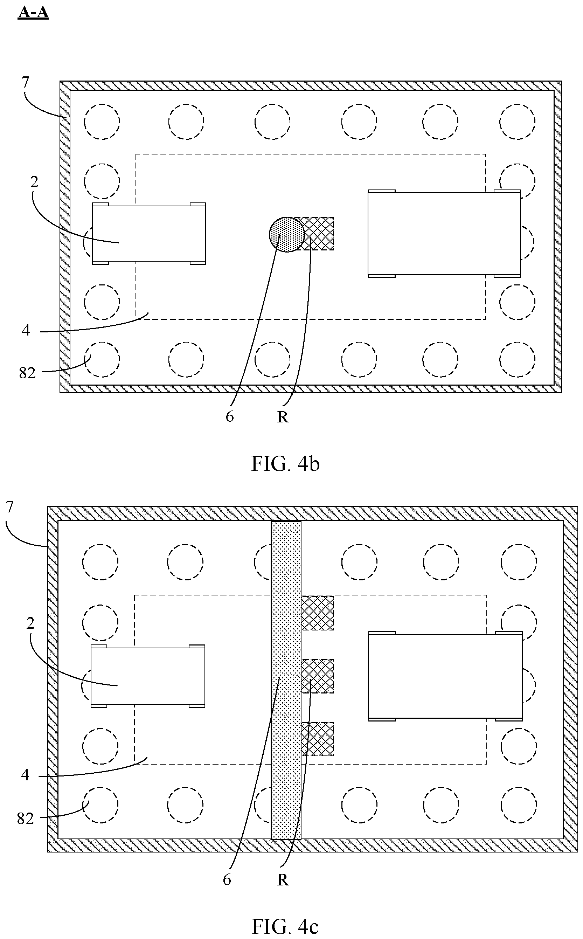

The structure shown in FIG. 4a is cut along a plane on which A-A is located, to obtain a structure shown in FIG. 4b. It can be seen that a position of the hotspot R on the die 4 corresponds to a position of the heat conduction structure 6, and an overlapping area exists between projections of the hotspot and the heat conduction structure on the package substrate 1, so that the heat of the hotspot R can be dissipated in time, thereby achieving a good heat dissipation effect.

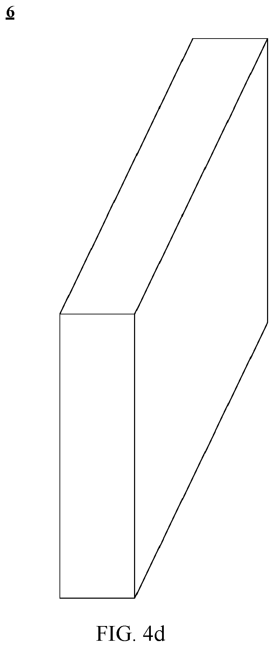

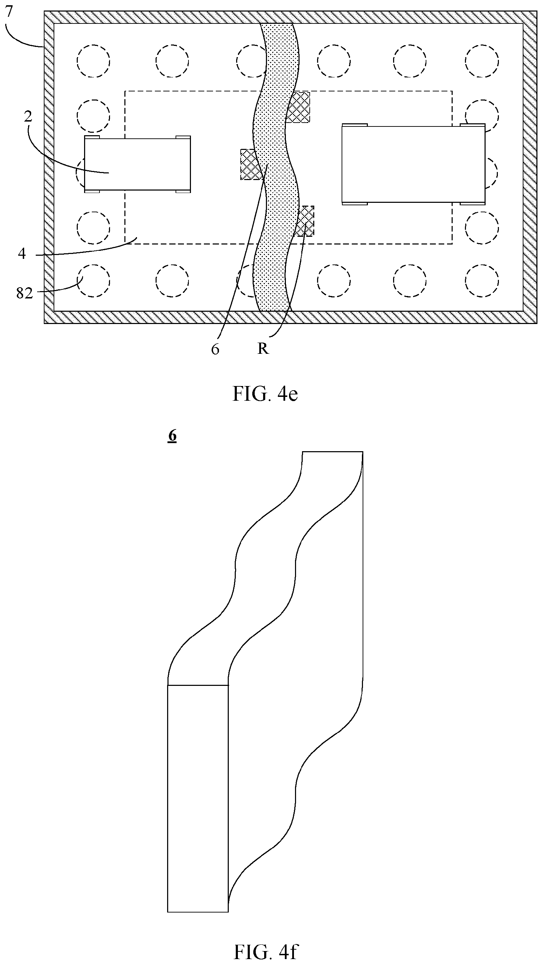

It should be understood that in the die package structures 10 shown in FIG. 4a and FIG. 4b, one hotspot R on the die 4 is shown, and one heat dissipation connection point 5 and one heat conduction structure 6 are also disposed. When a quantity of hotspots R on the die 4 is more than one, a quantity of corresponding heat dissipation connection points 5 and a quantity of heat conduction structures 6 may also increase, to ensure that the hotspots R, the heat dissipation connection points 5, and the heat conduction structures 6 can be in a one-to-one correspondence, thereby achieving a good heat dissipation effect. Alternatively, when a quantity of hotspots R on the die 4 is more than one, each hotspot R corresponds to one heat dissipation connection point 5, but a plurality of hotspots R may correspond to one heat conduction structure 6. With reference to FIG. 4c and FIG. 4e, a projection of one heat conduction structure 6 on the package substrate 1 overlaps all projections of a plurality of centralized hotspots R on the package substrate 1, and conduction can be performed for the plurality of centralized hotspots R to a same heat conduction structure 6 by using the heat dissipation connection point 5. For the heat conduction structure 6 in FIG. 4c, refer to FIG. 4d. For the heat conduction structure 6 in FIG. 4e, refer to FIG. 4f. For ease of explanation and description, in the following embodiments, an example in which one hotspot R corresponds to one heat conduction structure 6 is used for description.

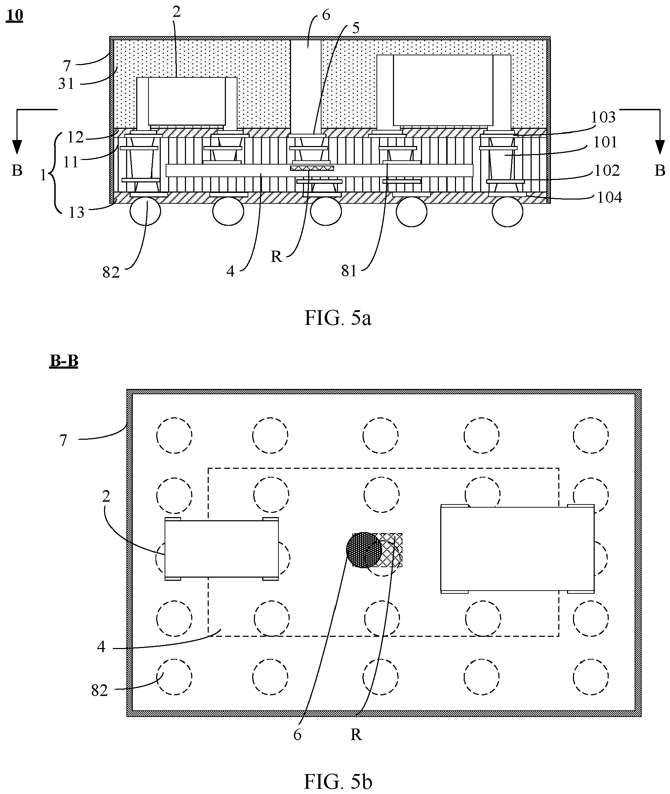

FIG. 5a shows a die package structure 10 of a SIP standard for which a semiconductor is embedded in a substrate. A package substrate 1 of the die package structure 10 specifically includes a substrate 11 and a first solder mask 12 and a second solder mask 13 that are formed on two surfaces of the substrate 11. A surface that is of the first solder mask 12 and that is away from the substrate 11 is equivalent to a first surface a1 of the package substrate 1, and a surface that is of the second solder mask 13 and that is away from the substrate 11 is equivalent to a second surface a2 of the package substrate 1. An electronic device 2 is disposed on a surface of the first solder mask 12 and is wrapped by a first package body 31. A die 4 is disposed in the substrate 11 in an embedded manner. An internal connection terminal 81 is disposed on a surface that is of the die 4 and that faces the first package body 31. A first connection terminal 82 is disposed on a side that is of the second solder mask 13 and that is away from the substrate 11, and the first connection terminal 82 protrudes from a second package body 32, to be coupled to a circuit board to implement an electrical signal connection. An electrical channel P that is formed in the substrate 11 and that is configured to connect the electronic device 2 and the die 4 may be formed by a via 101 and an inner circuit 102 that are disposed in the substrate 11. The via 101 and the inner circuit 102 are distributed in the substrate 11 as required. On the surface that is of the substrate 11 and on which the first solder mask 12 is disposed, a first soldering point 103 (the first soldering point 103 is connected to the via 101 herein) connected to the electrical channel P is disposed, and the electronic device 2 is connected to the first soldering point 103. On the surface that is of the substrate 11 and on which the second solder mask 13 is disposed, a second soldering point 104 (the second soldering point 104 is connected to the via 101 herein) connected to the electrical channel P is disposed. The second soldering point 104 is connected to the external connection terminal 82. A protective coating 7 is formed, through a sputtering process, on a surface of the die package structure 10 except a side (a side for interconnecting to a circuit board) on which the first connection terminal 82 is disposed.

To dissipate heat of a hotspot R on the die 4, a heat dissipation connection point 5 is specifically located on the surface that is of the substrate 11 and on which the first solder mask 12 is disposed, and the first solder mask 12 has an opening that exposes the heat dissipation connection point 5 (equivalent to that the heat dissipation connection point 5 is located on the first surface a1 of the package substrate 1). The electrical channel P located between the heat dissipation connection point 5 and the hotspot R may serve as a heat conduction channel Q. In the structure shown in FIG. 5a, the heat conduction channel Q is equivalently formed by the via 101 and the inner circuit 102, so that the heat of the hotspot R on the die 4 is transferred to a surface of the first package body 31 through the internal connection terminal 81, the via 101, the inner circuit 102, the heat dissipation connection point 5, and a heat conduction structure 6.

The structure shown in FIG. 5a is cut along a plane on which B-B is located, to obtain a structure shown in FIG. 5b. It can be seen that a position of the hotspot R on the die 4 corresponds to a position of the heat conduction structure 6, and an overlapping area exists between projections of the hotspot and the heat conduction structure on the package substrate 1, so that the heat of the hotspot R can be dissipated in time, thereby achieving a good heat dissipation effect.

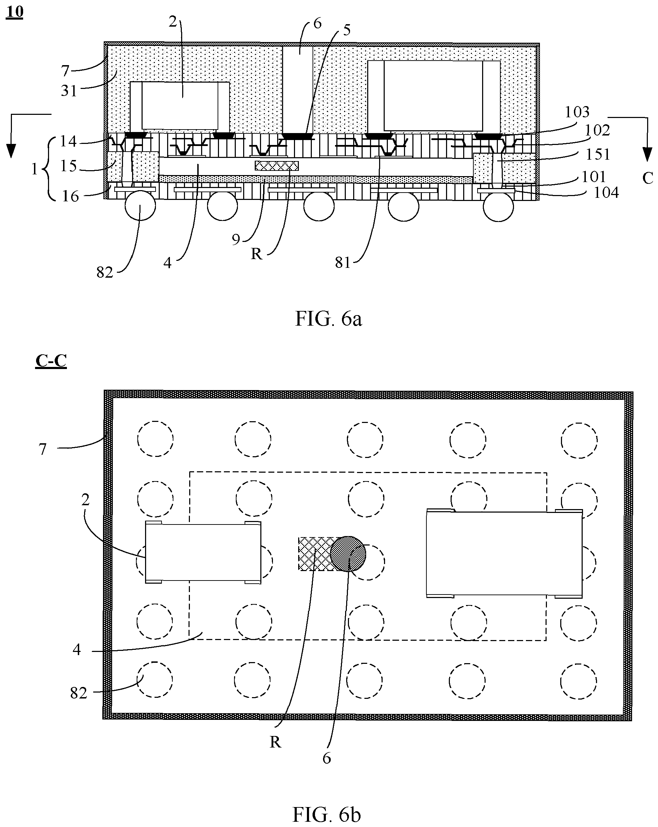

FIG. 6a shows a die package structure 10 of a laminated fanout SIP standard. A package substrate 1 of the die package structure 10 includes a first redistribution layer 14, a plastic packaging layer 15, and a second redistribution layer 16 that are disposed in a stacked manner. A surface that is of the first redistribution layer 14 and that is away from the second redistribution layer 16 is equivalent to a first surface a1 of the package substrate 1, and a surface that is of the second redistribution layer 16 and that is away from the first redistribution layer 14 is equivalent to a second surface a2 of the package substrate 1. An electronic device 2 is coupled to a surface of the first redistribution layer 14, and is wrapped by a first package body 31. The plastic packaging layer 15 is of an annular structure, and has a hollow area in a center. A die 4 is disposed in the hollow area of the plastic packaging layer 15 to be disposed at a same layer as the plastic packaging layer 15. At the structure layer at which the plastic packaging layer 15 and the die 4 are located, the plastic packaging layer 15 packages the die 4 between the first redistribution layer 14 and the second redistribution layer 16. This is equivalent to that the die 4 is coupled between the first redistribution layer 14 and the second redistribution layer 16, and is wrapped along a circumferential direction of the die 4. It should be understood that the die 4 may be considered as being of a sheet-like structure, and has a relatively small thickness (a thickness direction may be considered as a radial direction of the die 4). The die 4 has two opposite surfaces perpendicular to or approximately perpendicular to the thickness direction. The "circumferential direction" herein is a side surface located between two surfaces. Each of the first redistribution layer 14 and the second redistribution layer 16 includes a dielectric layer 9 and an inner circuit 102 formed in the dielectric layer 9. To implement electrical signal conduction between the first redistribution layer 14 and the second redistribution layer 16, a connection column 151 configured to connect the first redistribution layer 14 and the second redistribution layer 16 is further disposed in the plastic packaging layer 15, and the connection column 151 may be specifically a connector of a copper column. The connection column 151 may be alternatively replaced with another type of connector of a structure such as a connection line or a metal via, provided that electrical signal conduction between the first redistribution layer 14 and the second redistribution layer 16 can be implemented. The dielectric layer 9 is disposed between the die 4 and the second redistribution layer 16. In a fabrication process, the die 4 needs to be first fastened on the second redistribution layer 16. The dielectric layer 9 herein is configured to fasten the die 4 on the second redistribution layer 16. Specifically, the dielectric layer 9 may be a double-sided tape. After the die 4 is fabricated and plastically packaged, growth is directly performed to form the first redistribution layer 14 on a surface that is of the die 4 and that is away from the second redistribution layer 16. However, an internal connection terminal 81 is disposed on a surface that is of the die 4 and that faces the first package body 31. A first connection terminal 82 is disposed at the second redistribution layer 16, and the first connection terminal 82 is partially embedded in the second redistribution layer 16 and protrudes from a side surface that is of the second redistribution layer 16 and that is away from the first redistribution layer 14, so that the first connection terminal 82 is coupled to a circuit board to implement an electrical signal connection. An electrical channel P that is formed in the package substrate 1 and that is configured to connect the electronic device 2 and the die 4 may be formed by the inner circuit 102 disposed in the first redistribution layer 14. Based on a requirement, a via 101 may be provided at a proper position to implement electrical conduction. On the surface that is of the first redistribution layer 14 and that is away from the second redistribution layer 16, a first soldering point 103 (the first soldering point 103 is connected to the inner circuit 102 herein) connected to the electrical channel P is disposed, and the electronic device 2 is connected to the first soldering point 103. A second soldering point 104 (the second soldering point 104 is connected to the via 101 herein) connected to the electrical channel P is disposed in the second redistribution layer 16. The second soldering point 104 is connected to the first connection terminal 82. A protective coating 7 is formed, through a sputtering process, on a surface of the die package structure 10 except a side (a side for interconnecting to a circuit board) on which the first connection terminal 82 is disposed. To dissipate heat of a hotspot R on the die 4, a heat dissipation connection point 5 is specifically located on the surface that is of the first redistribution layer 14 and that is away from the second redistribution layer 16 (equivalent to that the heat dissipation connection point 5 is located on the first surface a1 of the package substrate 1). The electrical channel P located between the heat dissipation connection point 5 and the hotspot R may serve as a heat conduction channel Q. In the structure shown in FIG. 6a, the heat conduction channel Q is equivalently formed by the inner circuit 102, so that the heat of the hotspot R on the die 4 is transferred to a surface of the first package body 31 through the internal connection terminal 81, the inner circuit 102, the heat dissipation connection point 5, and a heat conduction structure 6.

The structure shown in FIG. 6a is cut along a plane on which C-C is located, to obtain a structure shown in FIG. 6b. It can be seen that a position of the hotspot R on the die 4 corresponds to a position of the heat conduction structure 6, and an overlapping area exists between projections of the hotspot and the heat conduction structure on the package substrate 1, so that the heat of the hotspot R can be dissipated in time, thereby achieving a good heat dissipation effect. It should be understood that, with reference to the structures of the die package structure 10 shown in FIG. 4a, FIG. 5a, and FIG. 6a, the heat conduction structure 6 may be flexibly disposed based on the different package structures. In addition, in a process of fabricating the die package structure 10, fabrication of the heat conduction structure 6 may be closely combined with an entire process of fabricating the die package structure 10.

It should be noted that the plastic packaging layer 15 plays a role of plastically packaging the die 4, and a material of the plastic packaging layer 15 is a general plastic packaging material, for example, epoxy resin. In addition, the material of the plastic packaging layer 15 may be the same as or different from that of the first package body 31.

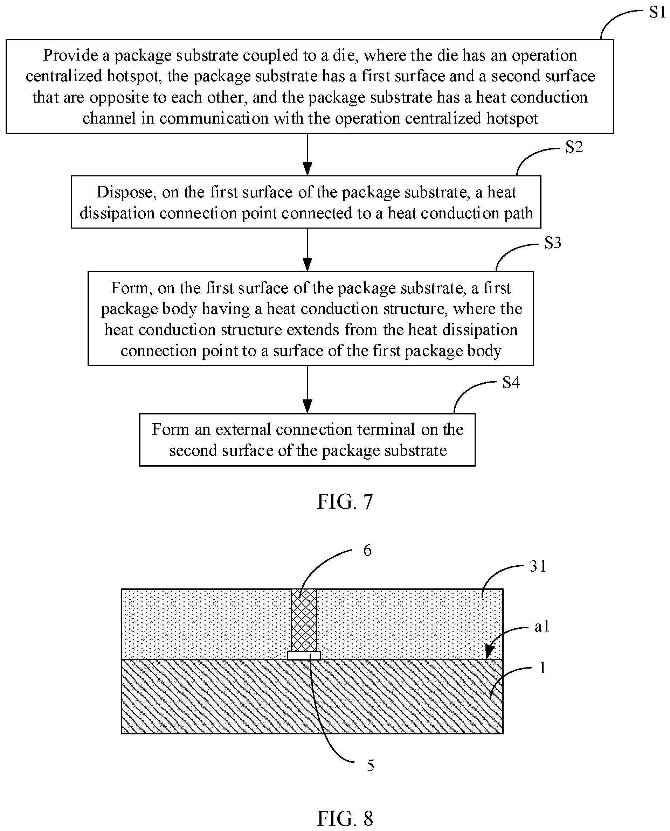

An embodiment of this application further provides a method for fabricating a die package structure, to fabricate the die package structure 10 in the foregoing embodiment. As shown in FIG. 7, the fabrication method includes the following steps: step S1: providing a package substrate 1 coupled to a die 4, where the die 4 has a hotspot R, the package substrate 1 has a first surface a1 and a second surface a2 that are opposite to each other, and the package substrate 1 has a heat conduction channel P in communication with the hotspot R.

With reference to FIG. 4a, FIG. 5a, and FIG. 6a in the foregoing embodiments, it can be learned that the "package substrate 1 coupled to the die 4" herein may have a plurality of forms, so that the die 4 may have different positions on the package substrate 1. Because a structure of the die 4 on the package substrate 1 is clearly shown in FIG. 4a, FIG. 5a, and FIG. 6a, details are not described herein again. In addition, common structures such as an electronic device 2, a via 101, an inner circuit 102, a first soldering point 103, a second soldering point 104, and an internal connection terminal 81 can be fabricated based on a conventional technical means in the art, and therefore are not described in detail herein.

It should be noted that, when the die 4 is located in the package substrate 1 (the structure shown in FIG. 4a or FIG. 6a), the die 4 completes coupling to the package substrate 1 before step S1. However, when the die 4 is located on the second surface a2 of the package substrate 1, the die 4 may be coupled to the package substrate 1 after a heat conduction structure 6 is disposed.

Step S2: Dispose, on the first surface a1 of the package substrate 1, a heat dissipation connection point 5 connected to the heat conduction channel P, where the heat dissipation connection point 5 may be specifically an example of a structure of a heat dissipation pad. Step S3: Form, on the first surface a1 of the package substrate 1, a first package body 31 having the heat conduction structure 6, where the heat conduction structure 6 extends from the heat dissipation connection point 5 to a surface of the first package body 31. In this case, for position structures of the package substrate 1, the heat conduction structure 6, and the heat dissipation connection point 5, refer to FIG. 8.

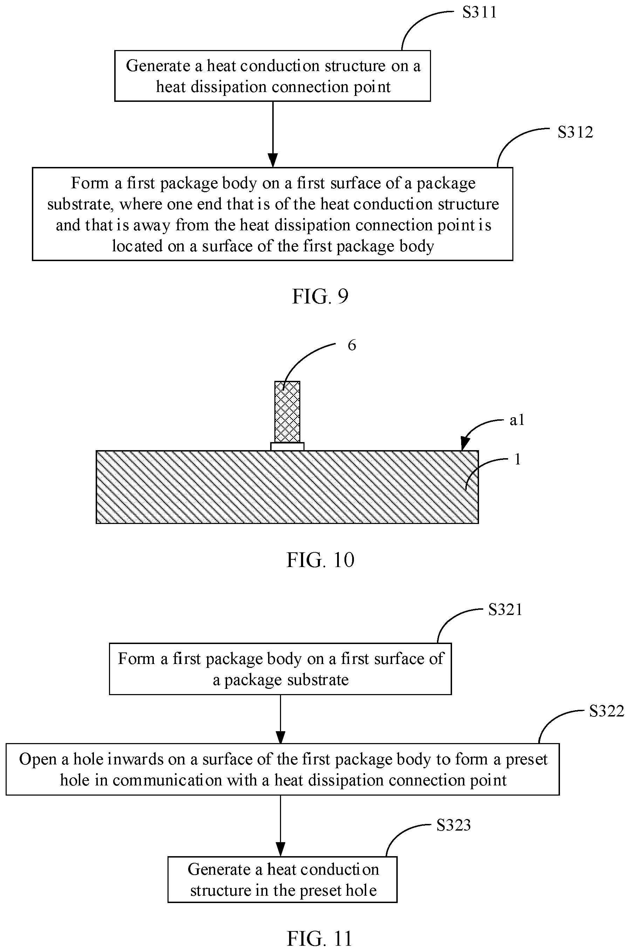

Specifically, to form a structure shown in FIG. 8, step S3 may have different implementations. In a specific implementation, as shown in FIG. 9, step S3 may include the following steps: Step S311: Generate the heat conduction structure 6 on the heat dissipation connection point 5 through soldering, growth, or the like, to obtain a structure shown in FIG. 10. Step S312: Form the first package body 31 on the first surface a1 of the package substrate 1, where one end that is of the heat conduction structure 6 and that is away from the heat dissipation connection point 5 is located on the surface of the first package body 31, to obtain the structure shown in FIG. 8.

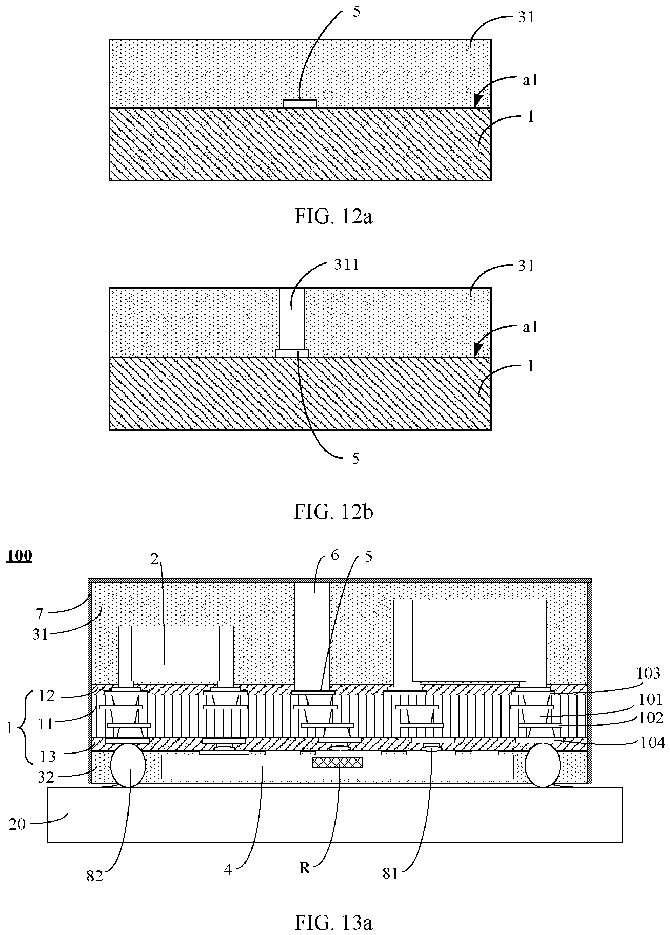

In another specific implementation, as shown in FIG. 11, step S3 may include the following steps: Step S321: Form the first package body 31 on the first surface a1 of the package substrate 1, to obtain a structure shown in FIG. 12a. Step S322: Open a hole inwards on the surface of the first package body 31 to form a preset hole 311 in communication with the heat dissipation connection point 5, to obtain a structure shown in FIG. 12b. Step S323: Generate the heat conduction structure 6 in the preset hole 51, to obtain the structure shown in FIG. 8.

Then, step S4 is implemented: Form a first connection terminal 82 on the second surface a2 of the package substrate 1. After step S4, a side surface that is of the entire structure and on which the first package body 31 is disposed further needs to be ground, so that a height of the entire structure is reduced to a designed height. To protect the structure, a protective coating 7 may be further formed on the surface of the first package body 31, and the protective coating 7 may cover the entire structure except a surface on a side of the second surface a2 of the package substrate 1.

Based on the die package structure 10 provided in the foregoing embodiments, an embodiment of this application further provides a package system 100. Based on the three structures shown in FIG. 4a, FIG. 5a, and FIG. 6a, the package system 100 provided in this embodiment of this application may be described by using FIG. 13a to FIG. 13c as examples.

Specifically, FIG. 3a shows a package system 100 of a double-sided mount SIP standard. The package system 100 includes the die package structure 10 shown in FIG. 4a and a circuit board 20. The circuit board 20 is coupled to the die package structure 10 by using a first connection terminal 82. The first connection terminal 82 may be specifically a solder ball, and the first connection terminal 82 may be connected to the circuit board 20, to implement electrical signal conduction between the die package structure 10 and the circuit board 20.

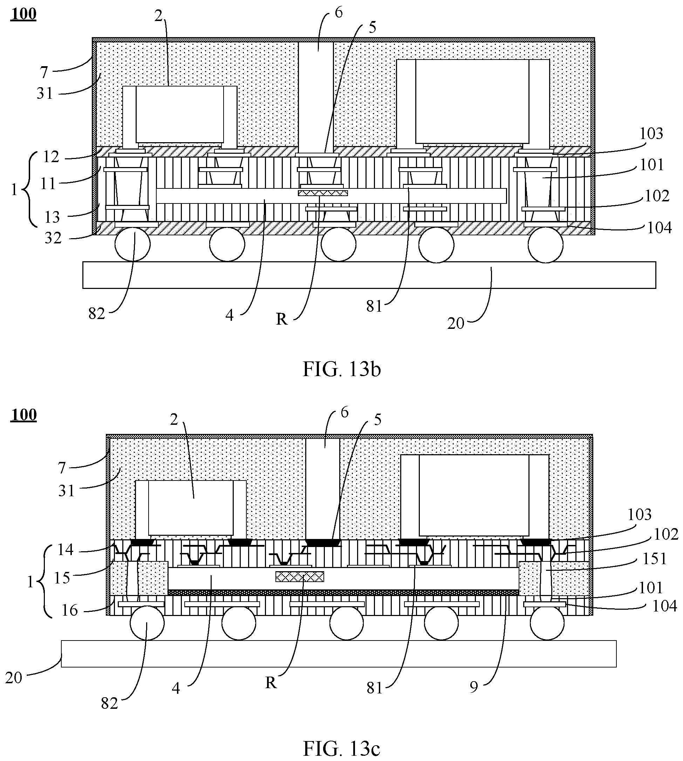

However, FIG. 13b shows a package system 100 of a SIP standard for which a semiconductor is embedded in a substrate. The package system 100 includes the die package structure 10 shown in FIG. 5a and a circuit board 20. The circuit board 20 is also coupled to the die package structure 10 by using a first connection terminal 82. The first connection terminal 82 may be specifically a solder ball, and the first connection terminal 82 may be connected to the circuit board 20, to implement electrical signal conduction between the die package structure 10 and the circuit board 20.

Similarly, FIG. 13c shows a package system 100 of a laminated fanout SIP standard. The package system 100 includes the die package structure 10 shown in FIG. 6a and a circuit board 20. The circuit board 20 is also coupled to the die package structure 10 by using a first connection terminal 82. The first connection terminal 82 may be specifically a solder ball, and the first connection terminal 82 may be connected to the circuit board 20, to implement electrical signal conduction between the die package structure 10 and the circuit board 20.

When being applied, the circuit board 20 in the foregoing embodiment may export a signal of the die 4 and communicate with an external device, to help the system implement a function. The circuit board 20 herein may be a PCB, an FPC, or an FPCB, and an appropriate circuit board 20 may be selected based on an application scenario.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A die package structure, comprising a package substrate, a die die, and a first package body, wherein
the die is coupled to the package substrate, and the die has a hotspot;
the package substrate has a first surface and a second surface that are opposite to each other, a heat dissipation connection point is disposed on the first surface, a heat conduction channel that communicates the heat dissipation connection point with the hotspot is formed in the package substrate, and a first connection terminal for connecting to an external device is disposed on the second surface; and
the first package body is disposed on the first surface, a heat conduction structure is formed in the first package body, and the heat conduction structure extends from the heat dissipation connection point to a surface of the first package body.

2. The die package structure according to claim 1, wherein a thermal resistance value of the heat conduction structure is less than a thermal resistance value of the first package body.

3. The die package structure according to claim 1 or 2, wherein the heat dissipation connection point is a heat dissipation pad.

4. The die package structure according to any one of claims 1 to 3, wherein the package substrate comprises a substrate, a first solder mask is formed on a surface that is of the substrate and that faces the first package body, and a second solder mask is formed on the other surface that is of the substrate and that is away from the first package body.

5. The die package structure according to claim 4, further comprising a second package body coupled to the second surface, wherein the first connection terminal protrudes from the second package body; and
the die is coupled to the second surface, the second surface is a surface that is of the second solder mask and that is away from the first package body, and the second package body is configured to wrap the die.

6. The die package structure according to claim 4, wherein the die is embedded in the substrate.

7. The die package structure according to any one of claims 1 to 3, wherein the package substrate comprises a first redistribution layer, a plastic packaging layer, and a second redistribution layer that are disposed in a stacked manner, and a connector configured to connect the first redistribution layer and the second redistribution layer is disposed in the plastic packaging layer; and
the die is coupled between the first redistribution layer and the second redistribution layer and is circumferentially wrapped by the plastic packaging layer, a first pad configured to connect to the first connection terminal is disposed in the second redistribution layer, and a via configured to communicate the first pad with the connector is further formed in the second redistribution layer.

8. The die package structure according to claim 7, further comprising a dielectric layer, wherein the dielectric layer is disposed between the die and the second redistribution layer to fasten the die to the second redistribution layer.

9. The die package structure according to any one of claims 1 to 8, further comprising an electronic device disposed on the first surface, wherein the first package body wraps the electronic device, and an electrical channel that communicates the electronic device with the die is formed in the package substrate.

10. The die package structure according to any one of claims 1 to 9, wherein a second connection terminal configured to connect to the package substrate is disposed on one surface that is of the die and that faces the first package body.

11. The die package structure according to any one of claims 1 to 10, further comprising a protective coating formed on a surface of the first package body.

12. A package system, comprising a circuit board and the die package structure according to any one of claims 1 to 11, wherein the circuit board is coupled to the die package structure by using external connection terminal.

13. A method for fabricating a die package structure, comprising:
providing a package substrate coupled to a die, wherein the die has a hotspot, the package substrate has a first surface and a second surface that are opposite to each other, and the package substrate has a heat conduction channel in communication with the hotspot;
disposing, on the first surface of the package substrate, a heat dissipation connection point connected to the heat conduction channel;
forming, on the first surface of the package substrate, a first package body having a heat conduction structure, wherein the heat conduction structure extends from the heat dissipation connection point to a surface of the first package body; and
forming a first connection terminal on the second surface of the package substrate.

14. The fabrication method according to claim 13, wherein the forming, on a first surface of the package substrate, a first package body having a heat conduction structure, wherein the heat conduction structure extends from the heat dissipation connection point to a surface of the first package body comprises:
generating the heat conduction structure on the heat dissipation connection point; and
forming the first package body on the first surface of the package substrate, wherein one end that is of the heat conduction structure and that is away from the heat dissipation connection point is located on the surface of the first package body.

15. The fabrication method according to claim 13, wherein the forming, on a first surface of the package substrate, a first package body having a heat conduction structure, wherein the heat conduction structure extends from the heat dissipation connection point to a surface of the first package body comprises:
forming the first package body on the first surface of the package substrate;
opening a hole inwards on the surface of the first package body to form a preset hole in communication with the heat dissipation connection point; and
generating the heat conduction structure in the preset hole.
